# EUROPEAN PATENT APPLICATION

(11) **EP 0 631 318 A1**
(43) Date of publication of application: **28.12.1994**
(21) Application number: 94109827.9
(22) Date of filing: 24.06.1994
(51) Int. Cl.: H01L 27/02

(54) **An integrated circuit having a diode voltage clamp for preventing damage by electrostatic discharge**

(30) Priority: 24.06.1993 JP 152543/93
(71) Applicant: NEC CORPORATION, Tokyo (JP)
(72) Inventor: Adachi, Masahiro, c/o NEC Corporation, Tokyo (JP)
(74) Representative: Glawe, Delfs, Moll & Partner

(57) **Abstract**

In order to effectively protect an integrated circuit (IC) against electrostatic discharge, a diode clamp is coupled across an internal IC circuit element which is to be protected from damage by electrostatic discharge. The diode clamp is arranged such that a forward current direction thereof is the same as a forward direction of the circuit element.

## Description

### BACKGROUND OF THE INVENTION

### Field of the Invention

The present invention relates generally to improvements in an integrated circuit, and more specifically to an integrated circuit having a diode voltage clamp via which damage by electrostatic discharge is effectively prevented without adversely affecting normal circuit operations.

### Description of the Prior Art

As is well known in the art, an integrated circuit is extremely susceptible to electrostatic discharge during handling. A human body is equivalent to 100pF in series with 1.5kΩ, by way of example. In winter the capacitor of a human body may charge to a few kilovolts with a simple arm motion with shirt or sweater. However, once a semiconductor device is safely set to its circuit, the chances for damages by electrostatic discharge are greatly reduced.

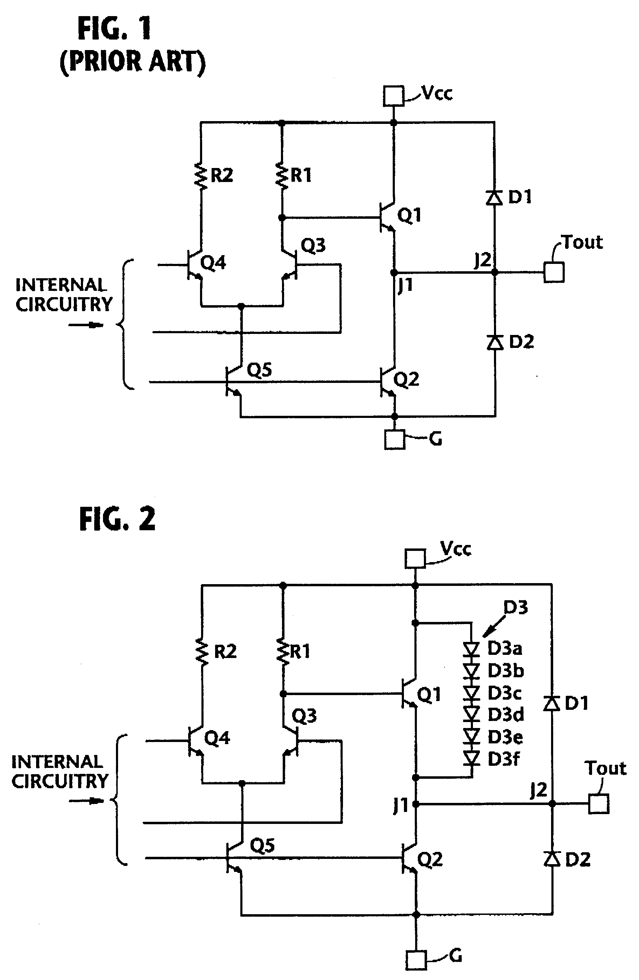

Before turning to the present invention it is deemed advantageous to briefly discuss, with reference to Fig. 1, a known integrated circuit which is provided with measures of safety for preventing irreversible damage by electrostatic discharge. The arrangement of Fig. 1 is disclosed in Japanese Laid-Open Patent Application No. 63-72146.

In Fig. 1, a bipolar type integrated circuit includes two output transistors Q1 and Q2 arranged in series between a power source terminal Vcc and a ground terminal G. The transistor Q1 is of an emitter follower type in this particular case. A junction J1 between the transistors Q1 and Q2 is coupled to an output terminal Tout. The integrated circuit of Fig. 1 further includes transistors Q3 and Q4 which form a differential amplifier together with two resistors R1 and R2. A transistor Q5 functions as a constant current source. Each of the bases of the transistors Q2 and Q3-Q5 are coupled to internal circuitry (not shown) of the integrated circuit of Fig. 1.

In order to prevent the output transistors Q1 and Q2 from being irreversibly damaged by static electricity discharged into the output terminal Tout, two diodes D1 and D2 are provided in series between the terminal Vcc and the ground terminal G. A junction J2 between the diode D1 and D2 is connected to the output terminal Tout.

If a static voltage discharged into the output terminal Tout is positive, the diode D1 is rendered conductive whereby a current bypath is established for the transistor Q1. Thus, the transistor Q1 is protected from being damaged by electrostatic discharge. Contrarily, if a static voltage discharged into the output terminal Tout is negative, the diode D2 is in turn rendered conductive and provides a bypass for the transistor Q2. Therefore, the transistor Q2 can be protected by the static electricity discharged into the terminal Tout.

However, the prior art shown in Fig. 1 is not sufficient in terms of protection against static voltage discharged into the power source terminal Vcc and also discharged into the ground terminal G. Further, the prior art fails to disclose that an integrated circuit is protected when a static electricity is discharged into an input terminal of the circuit.

It is therefore highly desirable to provide a diode clamp(s) for effectively protecting an integrated circuit from being damaged by static voltage discharged into a terminal(s) other than an output terminal.

### SUMMARY OF THE INVENTION

It is therefore an object of the present invention to provide an integrated circuit which is provided with at least one diode clamp for preventing the integrated circuit from being irreversiblY damaged by static voltage discharged into a terminal(s) other than an output terminal of the integrated circuit.

In brief, the above object is achieved by techniques wherein in order to effectively protect an integrated circuit (IC) against electrostatic discharge, a diode clamp is coupled across an internal IC circuit element which is to be protected from damage by electrostatic discharge. The diode clamp is arranged such that a forward current direction thereof is the same as a forward direction of the circuit element.

### BRIEF DESCRIPTION OF THE DRAWINGS

The features and advantages of the present invention will become more clearly appreciated from the following description taken in conjunction with the accompanying drawings in which like elements are denoted by like reference numerals and in which:
Fig. 1 is a circuit diagram of a known integrated circuit having been referred to the opening paragraphs of the instant disclosure;
Fig. 2 is a circuit diagram showing a first embodiment of the present invention;
Fig. 3 is a diagram showing a diode connection of a bipolar transistor;
Fig. 4 is a circuit diagram showing a second embodiment of the present invention;
Fig. 5 is a graph showing results of computer simulation conducted by an inventor;
Fig. 6 is a circuit diagram showing a third embodiment of the present invention when applied to a buffer coupled to an output terminal of an integrated circuit;
Fig. 7 is a circuit diagram showing a fourth embodiment of the present invention when applied to an emitter follower coupled to an input terminal of an integrated circuit;
Fig. 8 is a circuit diagram showing a fifth embodiment of the present invention when applied to a difference-amplifier coupled to an input terminal of an integrated circuit; and
Fig. 9 is a circuit diagram showing a sixth embodiment of the present invention when applied to a CMOS (Complementary Metal Oxide Semiconductor) type inverter.

### DETAILED DESCRIPTION OF THE PREFERRED EMBODIMENTS

Reference is now made to Fig. 2, wherein a first embodiment of the present invention is schematically illustrated. Throughout the instant disclosure, line reference notations are used to represent like portions.

As shown, the first embodiment includes a diode clamp D3 across the main path of the transistor Q1. Other than this, the first embodiment is same as the prior art of Fig. 1. However, the first embodiment is in no way limited to the integrated circuit shown in Fig. 2 and can be applied to any other integrated without departing from the scope of the instant invention.

In the embodiment illustrated in Fig. 2, the diode clamp D3 includes six diodes D3a-D3f which are coupled in series in a manner that the anode of D3a is coupled to the collector of the transistor Q1 while the cathode of D3f is coupled to the emitter of the transistor Q1.

The diode clamp D3 is to prevent the transistor Q1 from being irreversibly damaged by static voltage discharged into the power source terminal Vcc.

However, the diode clamp D3 should not adversely affect the operations of the transistor Q1 when the integrated circuit of Fig. 2 is soldered to its circuit (viz., mounted on a circuit board).

It is assumed that a power voltage applied to the terminal Vcc is 5V while the lowest output voltage appearing at the terminal Tout is 2V. In such a case, the number of diodes of the clamp D3 is six (6) as shown in Fig. 2. Each of the diodes D3a-D3f is rendered conductive if a forward voltage applied thereto is in excess of 0.6V. Thus, the diode clamp D3 is rendered conductive when a static voltage applied to the terminal Vcc exceeds 3.6V (=0.6V×6). It follows that the diode clamp D3 never adversely affect the normal operations of the transistor Q1 in that the voltage between the terminals Vcc and Tout is equal to or less than 3V when the transistor Q1 is in operation.

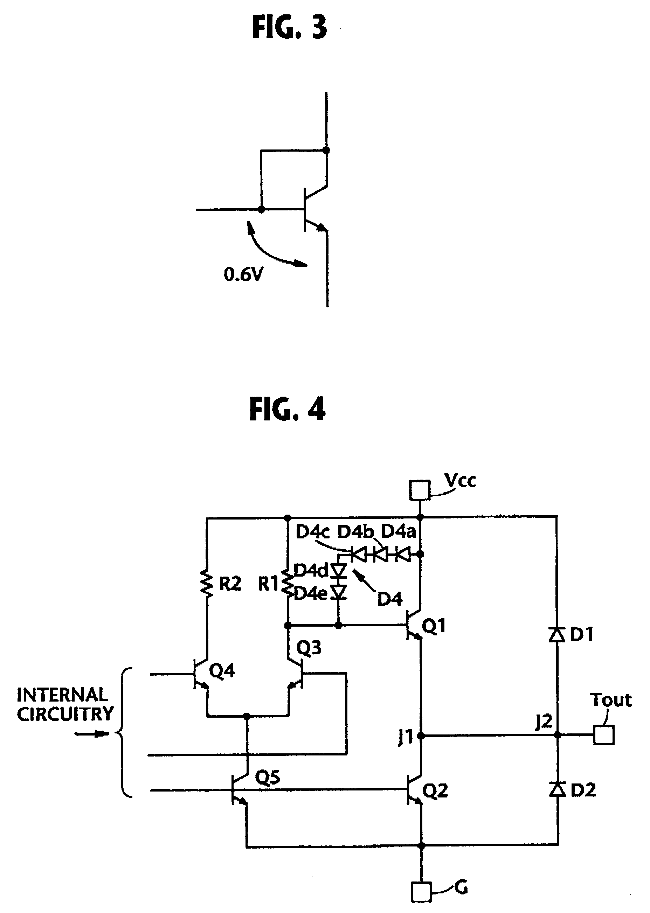

The reason why each of the diodes D3a-D3f becomes conductive when a voltage applied thereto exceeds 0.6V is that each diode is usually fabricated through direct coupling of the collector and base electrodes of a bipolar transistor as shown in Fig. 3.

Therefore, the number of diodes of the diode clamp D3 is determined depending on a DC (direct current) voltage applied to the terminal Vcc and an output voltage appearing at the terminal Tout.

Fig. 4 shows a circuit arrangement to which a second embodiment of the present invention is applied.

The second embodiment includes a diode clamp D4 which includes five (5) diodes D4a-D4e coupled in tandem and which is provided between the collector and the base of the transistor Q1. As in the first embodiment (Fig. 2), it is assumed that: (a) a power voltage applied to the terminal Vcc is 5V, (b) the lowest output voltage appearing at the terminal Tout is 2V and (c) each of the diodes D4a-D4e becomes conductive if a forward voltage applied thereto exceeds 0.6V.

The reason why the number of the diodes of the clamp D4 is five is that a diode between the base and collector of the transistor Q1 is coupled in series with the diode clamp D4 and is rendered conductive in excess of 0.6v.

If a static voltage discharged into the power source terminal Vcc exceeds 3.6V (=0.6V×6), a current path is established from the terminal Vcc to the terminal Tout. Thus, the transistor Q1 is protected against the electrostatic discharge.

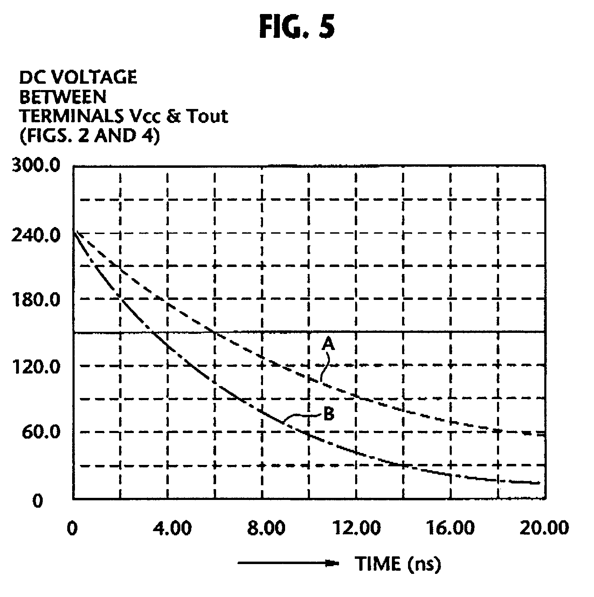

Fig. 5 shows results of the computer simulation conducted by the inventor. DC voltage of 250V was charged at a capacitor of 200pF and then discharged into the power source terminal Vcc while grounding the output terminal Tout. The resistance of the resistor R1 was 20KΩ. The transistor Q1 has an emitter whose dimensions was 1.5µ×81.5µ. Each of the diodes D3a-D3f and D4a-D4e is fabricated as shown in Fig. 3.

In Fig. 5, curves A and B indicate respectively discharge of the voltage applied to the terminal Vcc of the first and second embodiments (Figs. 2 and 4) with respect to the lapse of time. The computer simulation shows that the voltage of 250V is rapidly discharged without damage of the transistor Q1.

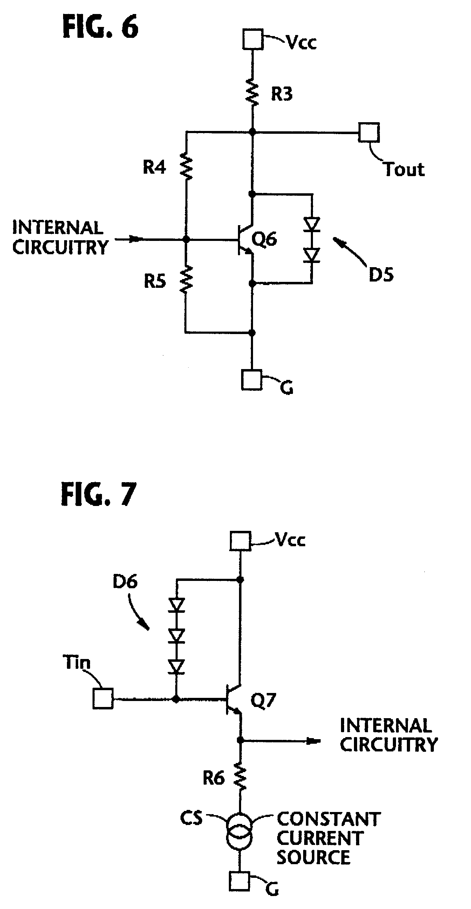

Figs. 6 through 9 illustrates respectively third to sixth embodiments of the present invention.

Fig. 6 is a circuit diagram showing the third embodiment of the present invention.

As shown in Fig. 6, a diode clamp D5 is coupled across a transistor Q6 which functions as a buffer together with resistors R4 and R5. A resistor R3 is a pull-up resistor. As mentioned above, the number of diodes included in a diode clamp is determined depending on a power voltage (Vcc) and a voltage appearing at the output terminal Tout. This is very important in order to assure normal operations of the integrated circuit into which the diode clamp is inserted. In the third embodiment, the diode clamp D5 includes two diodes by way of example. It will readily be appreciated from the foregoing how to protect the transistor Q6 against static voltage discharged into the terminal Vcc, and thus, further descriptions thereof will be omitted for brevity.

Fig. 7 is a circuit diagram showing the fourth embodiment of the present invention.

As shown in Fig. 7, a diode clamp D6 is coupled between the collector and the base of a transistor Q7 which operates as an emitter follower. As shown, an emitter resistor F6 and a constant current source CS are arranged in series between the emitter of Q6 and the gate terminal G. Further, the base of the transistor Q6 is directly coupled to an input terminal Tin. In this case, if a static voltage is discharged into the power source terminal Vcc, a bypath for the electrostatic discharge is established between the terminals Vcc and Tin via the diode clamp D6.

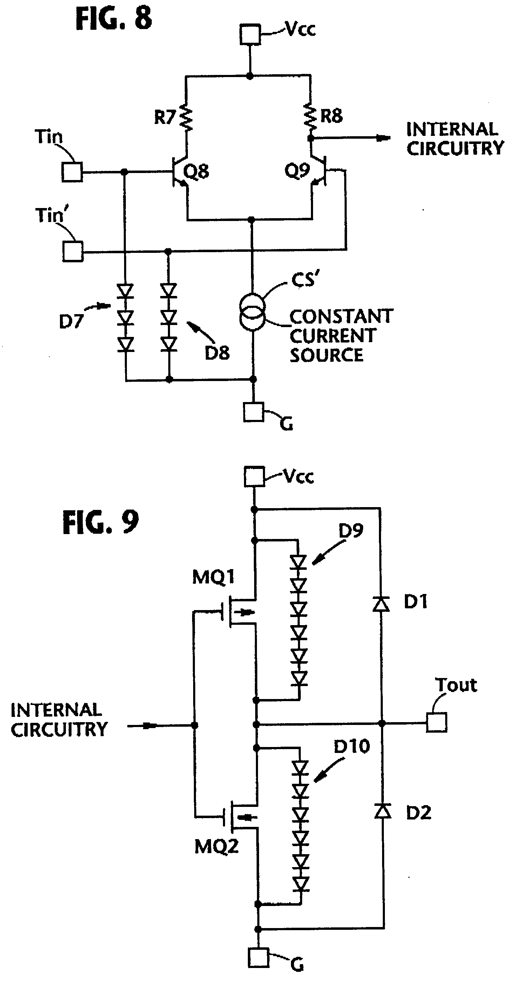

Fig. 8 is a circuit diagram showing a fifth embodiment of the present invention when applied to a difference-amplifier which includes transistors Q8-Q9 and resistors R7-R8. Further, Fig. 8 includes a constant current source CS' between the bases of the transistors Q8-Q9 and the ground terminal G. In order to prevent the transistor Q8 from being damaged by static voltage discharged into an input terminal Tin, a diode clamp D7 is provided as shown. Further, in order to prevent the transistor Q9 from being damaged by static voltage discharged into an input terminal Tin', a diode clamp D8 is provided. Two bypasses will be established between the terminal G and the terminals Tin and Tin' if static electricity applied to the terminals Tin and Tin'.

Finally, Fig. 9 is a circuit diagram showing a sixth embodiment of the present invention. The circuit of Fig. 9 includes an n-channel MOS (MQ1) and a p-channel MOS (MQ2) which operate as a CMOS inverter and which is provided between the terminals Vcc and G. A diode clamp D9 is provided for preventing MOS transistor MQ1 from being damaged by static voltage established between the terminals Vcc and Tout, while a diode clamp D10 is provided for preventing MOS transistor MQ2 from being damaged by static voltage between the terminals Tout and G.

It will be understood that the above disclosure is representative of sixth possible embodiments of the present invention and that the concept on which the invention is based is not specifically limited thereto.

## Claims

1. An integrated circuit, comprising:
a diode clamp coupled across a circuit element which forms part of said integrated circuit and which is to be protected from damage by electrostatic discharge, said diode clamp being arranged such that a forward direction thereof is same as a forward direction of said circuit element.

2. An integrated circuit as claimed in claim 1, wherein said diode clamp includes a plurality of diodes coupled in series.
